# EUROPÄISCHE PATENTSCHRIFT

(11) **EP 2 480 932 B1**
(45) Veröffentlichungstag und Bekanntmachung des Hinweises auf die Patenterteilung: **08.07.2020**
(21) Anmeldenummer: 10757764.5
(22) Anmeldetag: 24.09.2010
(51) Int. Cl.: G02F 1/35, G02F 1/355, H01L 21/306, B82Y 20/00

(54) **ELEKTROOPTISCHES BAUELEMENT UND HERSTELLUNG DES BAUELEMENTS**
ELECTRO-OPTIC COMPONENT AND PRODUCTION OF THE COMPONENT
COMPOSANT ÉLECTRO-OPTIQUE ET PRODUCTION DU COMPOSANT

(30) Priorität: 25.09.2009 DE 102009045037
(43) Veröffentlichungstag der Anmeldung: 01.08.2012
(73) Patentinhaber: Gesellschaft für Angewandte Mikro- und Optoelektronik mit Beschränkter Haftung - AMO GmbH, 52074 Aachen (DE)
(72) Erfinder: WÄCHTER, Markus, 40479 Düsseldorf (DE); MATHEISEN, Christopher, 41464 Neuss (DE); NAGEL, Michael, 41751 Viersen (DE); KURZ, Heinrich, 52076 Aachen (DE); BOLTEN, Jens, 52070 Aachen (DE); WAHLBRINK, Thorsten, 52072 Aachen (DE)
(74) Vertreter: Eisenführ Speiser
(86) Internationale Anmeldenummer: PCT/EP2010/064143
(87) Internationale Veröffentlichungsnummer: WO 2011/036250

(56) Entgegenhaltungen:
- WO-A1-02/061501
- US-A1- 2002 192 969
- Lin W. et al.: "Supramolecular Approaches to Second-Order Noninear Optical Materials. Self-assembly and Microstructural Characterization of Intrinsically Acentric [(Aminophenyl)azo]pyridinium Superlattices", , Bd. 118, Nr. 34 28. August 1996 (1996-08-28), Seiten 8034-8042, XP002615258, DOI: 10.1021/ja960395f Gefunden im Internet: URL:http://pubs.acs.org/doi/pdf/10.1021/ja 960395f [gefunden am 2010-12-22]
- Lin W. et al.: "Atomic Resolution X-ray Standing Wave Microstructural Characterization of NLO-Active Self-Assembled Chromophoric Superlattices", Journal of the American Chemical Society, Bd. 119, Nr. 9 5. März 1997 (1997-03-05), Seiten 2205-2211, XP002615257, DOI: 10.1021/ja962293v Gefunden im Internet: URL:http://pubs.acs.org/doi/pdf/10.1021/ja 962293v [gefunden am 2010-12-22]
- QIU MINGXIN ET AL: "Second-order optical nonlinearity generated by doping the surface layer of silica with anions or cations", JOURNAL OF APPLIED PHYSICS, AMERICAN INSTITUTE OF PHYSICS. NEW YORK, US, Bd. 88, Nr. 8, 15. Oktober 2000 (2000-10-15), Seiten 4666-4670, XP012051795, ISSN: 0021-8979, DOI: DOI:10.1063/1.1308068
- JACOBSEN R S ET AL: "Strained silicon as a new electro-optic material", NATURE, NATURE PUBLISHING GROUP, LONDON, GB, Bd. 441, 11. Mai 2006 (2006-05-11), Seiten 199-202, XP007901986, ISSN: 0028-0836, DOI: DOI:10.1038/NATURE04706

## Beschreibung

Die Erfindung betrifft ein elektrooptisches (EO) Bauelement, insbesondere eine Strahlungsquelle, Detektor und/oder einen elektrooptischen Modulator. Das elektrooptische Bauelement weist eine Wellenleiteranordnung auf, die eine Silizium und/oder Germanium basierte Anordnung hat.

Die Erzeugung von elektromagnetischen Signalen im Terahertz- (THz) Frequenzbereich mit Hilfe von kompakten, kostengünstigen, einfach zu betreibenden und robusten Quellen ist ein bislang nur unbefriedigend gelöstes technisches Problem.

Es existieren mehrere Ansätze, die jedoch mindestens einen der folgenden Nachteile besitzen wie etwa: hohe Kosten, geringe Ausgangsleitungen, große Systemabmessungen oder eine hohe technische Komplexität (z. B. Tieftemperaturbetrieb).

Die Entwicklung einer technischen Lösung dieses Problems ist von hoher wirtschaftlicher Bedeutung, da eine Vielzahl von neuen Anwendungen identifiziert werden konnte (etwa im Bereich der Sicherheitstechnik, Bioanalyse, zerstörungsfreier Materialprüfung oder Kommunikationstechnik), deren kommerzielle Umsetzung aufgrund der oben genannten Defizite der bisherigen THz-Signalquellen stark eingeschränkt ist.

Die vorliegende Erfindung betrifft die Erzeugung eines elektromagnetischen Signals im Frequenzbereich von 0,03 bis 270 THz mit Hilfe einer optisch angeregten Wellenleiteranordnung. Es werden zwei optische Anregungssignale mit unterschiedlicher Frequenz in einem Wellenleiter mit elektrooptischer Aktivität räumlich und zeitlich überlagert, wodurch ein drittes Signal (dessen Frequenz der Differenz oder Summe der beiden Anregungssignale entspricht) erzeugt wird. Die zwei optischen Anregungssignale können hier allgemein auch Teil eines Signalspektrums (z.B. in Form eines bandbreitenbegrenzten Laserpulses) sein, innerhalb dessen weitere Spektralanteile zur Differenz- bzw. Summenfrequenzerzeugung beitragen.

Dieses Prinzip ist grundsätzlich bereits bekannt und wurde erstmals im Jahr 1974 zur Erzeugung eines THz-Signals angewendet und in dem Artikel "Step-Tunable Far Infrared Radiation by Phase Matched Mixing in Planar-Dielectric Waveguides" von Thompson et. al., veröffentlicht in TRANSACTIONS ON MICROWAVE THEORY AND TECHNIQUES, Vol. MTT-22, Nr. 12, Dezember 1974, Seiten 995 ff. Als Wellenleiter wurde ein GaAs-Plättchen verwendet und als optische Quellen zwei CO₂-Laser mit ca. 10 µm Wellenlänge. Dieser Ansatz wurde jedoch erst vor kurzem wieder aufgegriffen, begünstigt durch die jüngsten Entwicklungen im Bereich effizienterer und kompakterer optischer Quellen und dem stark gestiegenen Interesse an THz-Anwendungen.

Eine neuere Patentanmeldung FR 2 817 630 beschreibt unter anderem den von Thompson et. al. gewählten Ansatz auf Basis eines GaAs-Wellenleiters.

In dem Artikel von Aleshkin et. al. mit dem Titel "Oscillations at a Difference Frequency in the Middle and Far Infrareds in GaP Semiconductor Waveguides", veröffentlicht in Technical Physics, 2006, Vol. 51, Nr. 9, Seiten 1207-1209, wird die Möglichkeit der Nutzung eines GaP Wellenleiters theoretisch betrachtet. Dies wurde von Chang et. al. gemäß dem Artikel mit dem Titel "GaP waveguide emitters for high power broadband THz generation pumped by Yb-doped fiber lasers", veröffentlicht in OPCTICS EXPRESS, Vol. 15, Nr. 25, 10. Dezember 2007, Seiten 16308 ff., experimentell umgesetzt.

Die meisten Ansätze verwenden Wellenleiter mit großen Querschnitten, die mehrere Übertragungsmoden (zumindest für die optischen Pumpsignale) zulassen. Ein erster Ansatz einer Kombination zweier Einzelmodenwellenleiter sowohl für das optische Anregungslicht als auch für das erzeugte THz-Signal wurde in dem Artikel von Staus et. al. mit dem Titel "Continuoulsy phase-matched terahertz difference frequency generation in an embedded-waveguide structure supporting only fundamental modes", veröffentlicht in OPTICS EXPRESS, Vol. 16, Nr. 17, 18. August 2008, Seiten 13296 ff., demonstriert. Als elektrooptisch aktives Material wurde Ti-dotiertes LiNbO₃ verwendet, das jedoch sehr instabile Materialeigenschaften besitzt und hohe Materialverluste aufweist.

Ein theoretisches Konzept einer Siliziumwellenleiteranordnung wurde in dem Artikel von Baehr-Jones et. al. mit dem Titel "Design of a tunable, room temperature, continuouswave terahertz source and detector using silicon waveguides", veröffentlicht J. Opt. Soc. Am. B, Vol. 25, Nr. 2, Februar 2008, publiziert. In diesem Konzept wurde als elektrooptisch aktives Material nicht der Siliziumwellenleiter selbst, sondern ein elektrooptisch aktives Polymer als Mantelmaterial vorgeschlagen, mit dem die hauptsächlich im Silizium geführten optischen Moden wechselwirken sollen. Technisch aufwändig ist dabei die Notwendigkeit einer Polung des Polymermaterials mit einem starken elektrostatischen Feld. Nachteilig ist die vergleichsweise hohe Absorption von Polymeren im THz-Bereich.

Wesentliche Nachteile der bisherigen Ansätze liegen in der Nutzung von nicht massenfertigungstauglichen Integrationsverfahren und der noch zu niedrigen Effizienz.

An dieser Stelle steht die Erfindung an, deren Aufgabe es ist, die Möglichkeit einer hocheffizienten Anordnung mit massenfertigungstauglichen Integrationsverfahren (z. B. CMOS-kompatibel) zu realisieren. Dazu soll ein elektrooptisches Bauelement, eine Vorrichtung mit dem Bauelement und ein Herstellungsverfahren für das Bauelement angegeben werden.

Die Aufgabe wird gelöst durch ein elektrooptisches Bauelement gemäß dem ersten unabhängigen Anspruch. Zur Erfindung gehört auch ein Herstellungsverfahren des Bauelements gemäß des zweiten unabhängigen Anspruches. Weitere Ausführungsformen sind in den abhängigen Ansprüchen aufgeführt.

Die folgenden Ausführungsformen in der Beschreibung und den Zeichnungen sind nicht alle beansprucht. Sie sind aufgeführt, um die Erfindung in ihren Zusammenhängen zu verstehen. Die beanspruchte Erfindung selbst ist definiert durch den Schutzumfang der unabhängigen Ansprüche. Jede Ausführungsform die nicht in deren Schutzumfang fällt, stellt lediglich grundlegenden Technikstand dar, der beispielhaft das Umfeld der Erfindung illustriert und das Verständnis der eigentlichen Erfindung erleichtert. Obwohl in der folgenden Beschreibung zahlreiche Merkmale als fakultativ, vorzugsweise und vorteilhaft aufgeführt sind, z.B. durch die Einführung als "kann", wird hiermit ausdrücklich klargestellt, dass alle Merkmale des jeweiligen unabhängigen Anspruches zwingend zur Erfindung gehören.

Das elektrooptische Bauelement weist vorzugsweise eine Wellenleiteranordnung auf, die eine Silizium und/oder Germanium basierte Anordnung hat. Es wird für die Silizium und/oder Germanium basierte Anordnung unter anderem vorgeschlagen, dass die Silizium und/oder Germanium basierte Anordnung aufweist:
- ein Silizium- und/oder Germaniummaterial mit einer Oberfläche, wobei
- die Oberfläche mit einer Halogenanreicherung chemisch modifiziert und mit dem Silizium- und/oder Germaniummaterial elektrooptisch aktiviert ist.

Mit anderen Worten, wird das Silizium- und/oder Germaniummaterial mittels der Oberfläche zusammen mit dieser elektrooptisch aktiviert. Es wird erstmals Silizium und/oder Germanium selbst als elektrooptisch (EO) aktives Material genutzt. Silizium und/oder Germanium besitzt von Natur aus keine EO Aktivität im Materialvolumen bzw. einen durch den Suszeptibilitätstensor χ⁽²⁾ beschriebenen nichtlinear-optischen Effekt zweiter Ordnung, da es eine zentrosymmetrische Kristallstruktur besitzt. In zentrosymmetrischen Kristallen liegt allgemein lediglich ein nichtlinear-optischer Effekt dritter Ordnung vor, der jedoch ein deutlich geringeres technisches Anwendungspotential besitzt. Es wurde jedoch erkannt, dass in Silizium oder einem anderen Material mit zentrosymmetrischer Kristallstruktur, wie Germanium über eine chemische Modifizierung der Oberfläche mit Bindungsmolekülen hoher Elektronegativität eine EO Aktivität äußerst effizient in Oberflächennähe induziert werden kann, die zur Realisierung siliziumbasierter elektrooptischer Bauelemente, wie eine Signalquelle, ein Detektor und/oder ein Modulator genutzt werden kann. Zusätzlich verstärkt werden kann dieser Effekt durch eine mechanische Verspannung oder ein externes elektrisches Feld.

Weitere vorteilhafte Weiterbildungen der Erfindung sind den Unteransprüchen zu entnehmen und geben im Einzelnen vorteilhafte Möglichkeiten an, das oben erläuterte Konzept im Rahmen der Aufgabenstellung sowie hinsichtlich weiterer Vorteile zu realisieren.

Die Halogenanreicherung ist in besonders bevorzugter Form als Bromanreicherung gebildet. Brom hat sich hinsichtlich seiner Elektronegativität und Flüchtigkeit als besonders geeignet im Unterschied zu anderen Halogenen erwiesen. Insbesondere kann Brom vorteilhaft in Anreicherungsverfahren genutzt werden und bildet überraschenderweise ausgesprochen homogene und hohe Belegungsdichten an der Oberfläche. Vergleichsweise gut gegenüber anderen Halogenen hat sich bei Brom gezeigt, dass es möglich ist, eine weitgehend geordnete und auf eine bzw. eine geringste Anzahl von Monolagen beschränkte Bromanreicherung der Silizium- und/oder Germaniumoberfläche zu realisieren.

Auch wenn diese Vorteile aufgrund höherer Diffusionsneigung von Fluor oder Chlor nicht so gut wie bei Brom ausgebildet sind, so hat es sich dennoch als konstruktiv vorteilhaft erwiesen, dass eine Halogenanreicherung eines oder mehrerer Halogene die Oberfläche durch eine kovalente Bindung des Halogens an ein Silizium- und/oder Germaniumatom der Oberfläche modifizieren kann. Vorteilhaft reichert das Halogen dabei die Oberfläche in atomarer Form an. Eine solche von der Weiterbildung vorteilhaft erkannte kovalente Bindung führt zu einer hohen Belegungsdichte von Dipolen, die in der Regel zudem homogen über die Oberfläche verteilt sind. Die Erfindung hat erkannt, dass diese überraschende Erkenntnis in besonders vorteilhafter Weise zur Realisierung eines elektrooptisch aktivierten Silizium- und/oder Germaniummaterials beim elektrooptischen Bauelement genutzt werden kann.

Es ist gleichwohl nicht auszuschließen, dass auch intermolekulare Wechselwirkung, wie Wasserstoffbrücken oder van der Vaals-Kräfte für eine Halogenanreicherung genutzt werden kann. Grundsätzlich stehen dafür auch halogenbasierte Stoffe, wie Moleküle oder Komplexe zur Verfügung, wobei jedoch gewährleistet ist, dass das Halogen an der Oberfläche - sei es durch eine kovalente Bindung oder eine intermolekulare Wechselwirkung - gebunden ist. Insbesondere im Fall eines Vorliegens des Halogens mit einem Komplex kann eine koordinative Bindung des Halogens an die Silizium- und/oder Germaniumoberfläche erfolgen. Der Komplex kann beispielsweise mit dem Halogen an die Silizium- und/oder Germaniumoberfläche, in der Regel kovalent, gebunden sein und eine oder mehrere funktionale Gruppen aufweisen, welche als Elektronendonator wirkt. Gleichwohl dienen solche koordinativen Bindungen regelmäßig als elektronentransferierende Bindungen, die nur in sekundärer Funktion zur Ausbildung von Dipolen genutzt werden. Die Bildung von Dipolen durch eine atomare Silizium-Halogen-Kovalenzbindung ist mit einer wesentlich homogeneren und höheren Dipoldichtenbildung verbunden, so dass die beanspruchte Weiterbildung mit einer kovalenten Bindung und/oder einer Anreicherung in atomarer Form des Halogens gegenüber einer koordinativen Bindung eines halogenbasierten Komplexstoffes bevorzugt ist.

Eine hohe Konversionseffizienz wird weiterhin dadurch begünstigt, dass für Silizium- und/oder Germaniumwellenleiter mit kleinen Querschnitten sehr effiziente Halbleiterstrukturierungsverfahren genutzt werden können, die es ermöglichen, Anregungsfelder bei geringen Verlusten extrem stark zu Bündeln und so die für die nichtlinearoptische Frequenzmischung vorteilhaften hohen Intensitäten in Oberflächennähe bereitzustellen. Undotiertes sowie schwach dotiertes Silizium und/oder Germanium besitzt zudem sowohl im optischen Anregungsbereich als auch im THz-Frequenzbereich eine sehr hohe Transparenz. Das Verfahren bietet die Möglichkeit sowohl eine THz-Signalerzeugung innerhalb integrierter photonischer Anwendungen als auch in Einzelkomponenten zu realisieren.

Das Konzept der Erfindung dient vorteilhaft zur Bildung einer THz-Signalquelle, -Detektor und/oder Modulator zur Verwendung innerhalb eines Systems, etwa zum Aufspüren von Gefahrstoffen oder verdeckten Gegenständen, der zerstörungsfreien Materialprüfung, der markierungsfreien Biomoleküldetektion, der Gasanalyse oder Mikropartikelanalyse.

Die Wellenleiteranordnung, das Bauelement und die THz-Quelle nutzen eine optische Signalerzeugung vorteilhaft im Millimeterwellenbereich (0,03-0,3 THz), Terahertz-Frequenzbereich (0,3-30 THz) und Infrarotbereich (30-270 THz).

Ausführungsbeispiele der Erfindung werden nun nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, der Zeichnung und/oder den Ansprüchen offenbarten Merkmale. Die allgemeine Idee der Erfindung ist nicht beschränkt auf die exakte Form oder das Detail der im Folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein. Der Einfachheit halber sind nachfolgend für identische oder ähnliche Teile oder Teile mit identischer oder ähnlicher Funktion gleiche Bezugszeichen verwendet.

Weitere Vorteile, Merkmale und Einzelheiten der Erfindung ergeben sich aus der nachfolgenden Beschreibung der bevorzugten Ausführungsbeispiele sowie anhand der Zeichnung; diese zeigt in:
Fig. 1 eine schematische Darstellung eines passiven Bauelements in Form einer Wellenleiteranordnung zur optischen Signalerzeugung im Terahertz-Frequenzbereich gemäß einer ersten bevorzugten Ausführungsform;
Fig. 2 eine schematische Darstellung einer zweiten vereinfachten Ausführungsform des Wellenleiters;
Fig. 3 eine schematische Darstellung einer dritten Ausführungsform eines Wellenleiters in Form eines Rippenwellenleiters;
Fig. 4 eine schematische Darstellung einer vierten Ausführungsform eines Wellenleiters in Form eines Streifenwellenleiters;
Fig. 5 eine schematische Darstellung einer fünften Ausführungsform eines Wellenleiters in Form eines Metall/Dielektrikum Hybridwellenleiters;
Fig. 6 eine schematische Darstellung einer sechsten Ausführungsform eines Wellenleiters in Form eines dielektrischen Hybridwellenleiters;
Fig. 7 ein exemplarisches Ergebnis einer SHG-Messung zum Nachweis von Brom-bindungen auf einer Siliziumoberfläche eines passiven Bauelements gemäß einer bevorzugten Ausführungsform;
Fig. 8 eine Effizienzmessung für eine optisch generierte Signalerzeugung im Terahertz-Frequenzbereich gemäß dem Konzept der Erfindung (HBr akt. SOI) im Vergleich zu einer Standardquelle InGaAs.

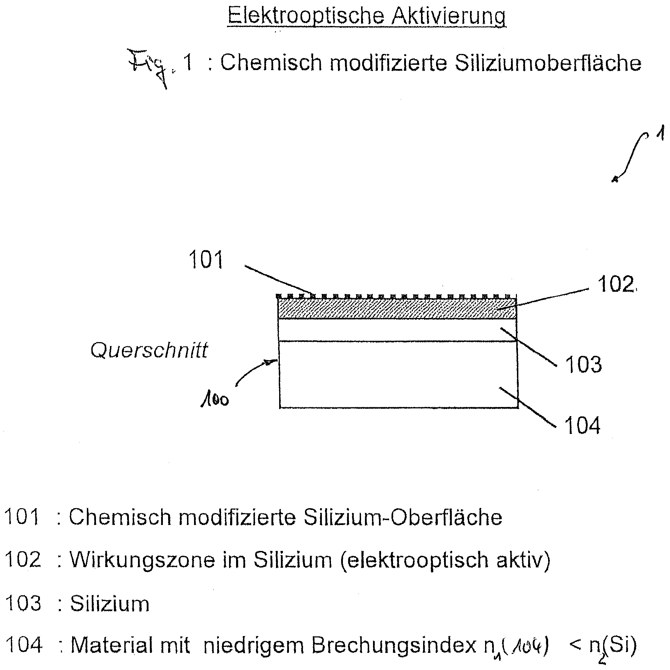

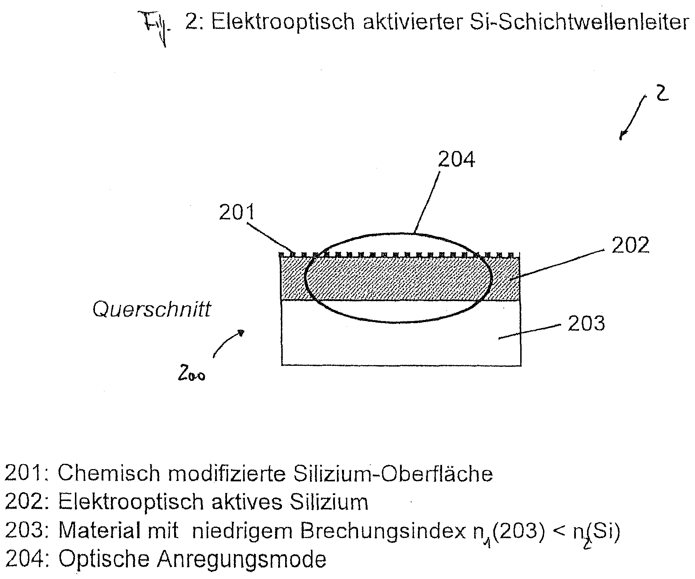

Das in Fig. 1 schematisch gezeigte Bauelement 1 weist eine im Querschnitt dargestellte Silizium basierte Anordnung 100 gemäß dem Konzept der Erfindung auf, welche zur Differenz- oder Summenfrequenzerzeugung, vorliegend eines Terahertz-Signals, ausgelegt ist. Die als Schichtanordnung ausgeführte Anordnung 100 weist eine erste Schicht eines Materials 104 mit einem ersten Brechungsindex n₁ und eine Doppelschicht eines Siliziummaterials bestehend aus einer EO aktiven Schicht 102 und einer EO inaktiven Schicht 103 die jeweils einen zweiten Brechungsindex n₂ aufweisen. Schicht 102 besitzt eine chemische Oberflächenmodifizierung 101 in Form von Silizium-Halogen-Bindungen, welche die EO Aktivität der Schicht 102 verursacht. Dem Konzept der Erfindung folgend, ist der Brechungsindex n₁ des Materials 104 jedenfalls geringer als der Brechungsindex n₂ des Siliziummaterials 102, vorliegend des Siliziummaterials bestehend aus 102 und 103. Dies hat zur Folge, dass bei einer optischen Anregung auf den Querschnitt der Siliziumschicht 102,103 in Fig. 1 eine Beschränkung der optischen Anregungsmode auf die Schicht des Siliziummaterials 102 und 103 in Ausbreitungsrichtung der Anregungsmode erhalten bleibt. Modifikationen und Verbesserungen gemäß verschiedenen Ausführungsformen eines EO Bauelements, insbesondere des Wellenleiters, sind in den folgenden Fig. 2 bis Fig. 6 erläutert. Diese dienen insbesondere der Erhöhung der Intensität der optischen Mode im EO aktiven Siliziummaterial 102 und an dessen Oberfläche 101 und der phasenangepassten Führung des Anregungssignals und des erzeugten THz Signals.

Grundsätzlich eignet sich das in Fig. 1 dargestellte EO Bauelement nicht nur als Wellenleiter, sondern auch z.B. als Strahlungsquelle, Detektor und/oder elektrooptischer Modulator für ein Signal im Millimeterwellenlängenbereich, Terahertz-Frequenzbereich und/oder Infrarotbereich. Die Detektion bzw. Strahlungserzeugung kann wiederum durch eine optische Signalkopplung erfolgen, ohne dass das Bauelement 1 als lateral begrenzter Wellenleiter ausgebildet sein müsste.

Gemäß dem Konzept der Erfindung ist vorliegend der χ⁽²⁾-Effekt (die benannte EO Aktivität zweiter Ordnung) einer Signalerzeugung im Millimeterwellenbereich, Terahertz-Frequenzbereich und/oder Infrarotbereich an der Oberfläche des EO aktiven Siliziummaterials 102 - wie sich zeigt - ganz erheblich erhöht worden - dies als Folge einer chemisch modifizierten Oberfläche 101 mit Hilfe einer Halogenanreicherung. Unter den Halogenen Fluor, Chlor, Brom und Iod hat sich Brom als besonders effektiv erwiesen. Die Bromanreicherung ist als echte chemische Bindung zwischen atomarem Brom und Silizium der Oberfläche gebildet und führt zu einer für den χ⁽²⁾-Effekt vorteilhaften atomaren Ladungsverschiebung (Polarisation) an der Oberfläche 101. Dies wiederum ermöglicht unter optischer Anregung die phasenrichtige Kopplung und Anregung von atomaren Dipolen an der Oberfläche 101 und führt damit zu einer mit der optischen Anregung phasengekoppelten Erzeugung von Signalen im Millimeterwellenbereich, Terahertz-Frequenzbereich und/oder Infrarotbereich.

Brom hat im Unterschied zu anderen Halogenen besonders vorteilhafte Eigenschaften zur Bildung der atomaren Dipolschicht und der atomaren Ladungsverschiebung im Rahmen einer Brom-Silizium-Bindung an der Oberfläche 101 wie eine hohe Oberflächendichte, Homogenität und thermische Stabilität.

Die Oberfläche 101 ist zur Bromanreicherung bei der vorliegenden Ausführungsform plasmaaktiviert worden, nämlich im Rahmen eines an sich bekannten RIE-Trockenplasma-Ätzverfahrens. Vorliegend wurde pures HBr ohne weitere Zusatzgase für die Trockenplasmaaktivierung verwendet. Es hat sich dabei überraschend gezeigt, dass die Oberfläche 101 unter Bromanreicherung praktisch instantan konditioniert wird. Vorteilhaft wird dabei Oxid durch lonenbeschuss von der Oberfläche entfernt, so dass eine Bromanbindung weitgehend ungehindert stattfinden kann. Überschüssiges ungebundenes Brom entweicht praktisch instantan unter Atmosphärenbedingungen und es verbleibt eine mit Brom-Silizium-Bindungen angereicherte Oberfläche 101. Wie von der Erfindung erkannt, haben diese Umstände zur Folge, dass die χ⁽²⁾-Nichtlinearität an der Oberfläche 101 unverhältnismäßig groß ist und somit zu einer besonders erhöhten Effizienz bei der Erzeugung von Signalen in Millimeterwellen-, Terahertz- und/oder Infrarot-Bereich führt.

Grundsätzlich kann die Konditionierung der Oberfläche 101 auch im Rahmen eines nasschemischen Ätzverfahrens erfolgen, beispielsweise unter Spaltung der Siliziumoberfläche in einer bromhaltigen Lösung oder nach einer erfolgten Reinigung, z. B. HF-Reinigung zur Entfernung von Oxiden oder durch elektrochemische Ätzung in einer Br-HF-Lösung.

Die grundsätzliche Struktur des in Fig. 1 beschriebenen EO Bauelements 1 kann in vorteilhafter Weise auch bei einem Wellenleiter der Fig. 2 bis Fig. 6 übernommen werden, welcher in einer zweiten bis sechsten Ausführungsform nachfolgend beschrieben wird.

Fig. 2 zeigt dazu ein EO Bauelement 2 in Form einer Wellenleiteranordnung mit einer im Querschnitt gezeigten siliziumbasierten Anordnung 200. Diese wird gebildet aus einem Material 203 mit ersten Brechungsindex n₁, einem EO aktiven Siliziummaterial 202 eines zweiten Brechungsindex n₂ und einer wie in Fig. 1 beschriebenen chemisch modifizierten Oberfläche 201 mit einer Bromanreicherung. Eine optische Anregungsmode 204 ist in Folge der stark unterschiedlichen Brechungsindizes n₂ (Si, 202) > n₁ (203) stark beschränkt auf die Schicht des elektrooptisch aktiven Siliziummaterials 202 und dessen Oberfläche 201 mit der Bromanreicherung. Die Schichtdicke des elektrooptisch aktiven Siliziummaterials 202 beträgt vorliegend 200 nm, während die Schichtdicke des Materials 203 mit niedrigem Brechungsindex n₁ bei 2 µm liegt. Das Material niedrigen Brechungsindexes ist vorliegend aus einem Siliziumoxid gebildet. Andere Ausführungsformen, die vorliegend nicht gezeigt sind, können beispielsweise auch ein Material auf Basis von Cyclo-Olefin-CoPolymer (COC) oder eines Benzocyclobuthen (BCB), eines SU8 oder eines PMMA oder sonstigem transparenten Polymers gebildet sein. Um eine optische Anregung mit der Intensitätsüberhöhung in der EO aktiven Siliziumschicht 202 unterliegenden Mode 204 vorteilhaft zu gestalten, ist es - wie im vorliegenden Beispiel der Silizium basierten Anordnung 200 - wichtig, dass das Material 203 mit niedrigem ersten Brechungsindex n₁ vergleichsweise dick gegenüber dem EO aktiven Siliziummaterial 202 ausgeführt ist, um eine verlustarme Führung der optischen Anregungsmode und eine starke Wechselwirkung der in dem EO aktiven Siliziummaterial 202 geführten Anregungsmode 204 zu den Dipolen der Silizium-Brom-Bindungen an der Oberfläche 201 zu gewährleisten. Insbesondere hat es sich dabei als vorteilhaft erwiesen, dass das Material 203 niedrigen Brechungsindexes eine größere Bandlücke als Silizium besitzt. Dies ist bei den oben genannten Materialien SiO₂, COC, BCB, SU8, PMMA der Fall. Die vom Konzept der Erfindung zu fördernden Effekte einer phasenangepassten Kopplung werden somit nicht gestört durch dispersive Effekte, die durch Ladungsträgeranregung oder dergleichen verursacht sein könnten.

Um eine volle Ausbildung einer phasengerechten Signalerzeugung im Millimeter- bzw. Terahertz- bzw. Infrarotbereich zu erreichen, weist die Silizium basierte Anordnung 200 für die Ausbildung eines Wellenleiters eine ausreichende Länge von vorliegend 5 mm auf. Je nach Anwendungsfall kann sich auch eine ähnliche Erstreckung einer Wellenleiteranordnung im Bereich von 1-10 mm als ausreichend erweisen.

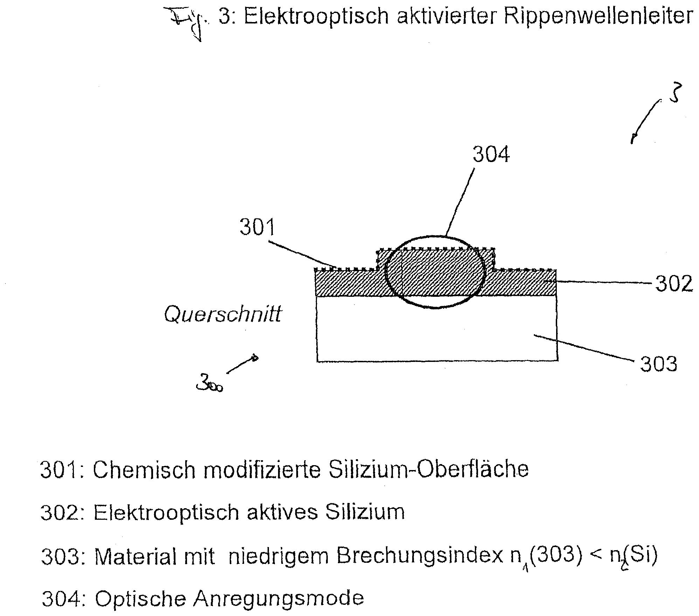

In Fig. 3 ist ein weiteres elektrooptisches Bauelement 3 mit einer siliziumbasierten Anordnung 300 im Querschnitt gezeigt, welche hinsichtlich der Materialien im Wesentlichen der Anordnung 200 der Fig. 2 entspricht. Allerdings ist vorliegend das EO aktive Siliziummaterial 302 in einer Rippenstruktur ausgebildet, so dass die optische Anregungsmode 304 auch seitlich eng eingegrenzt ist auf das EO aktive Siliziummaterial 302. Unterstützt wird diese weitere Intensitätsüberhöhung - wie erläutert - durch den niedrigen Brechungsindex des Materials 303, dessen optische Transparenz und die wesentlich dickere Ausführung des Materials 303 im Vergleich zum EO aktiven Siliziummaterial 302.

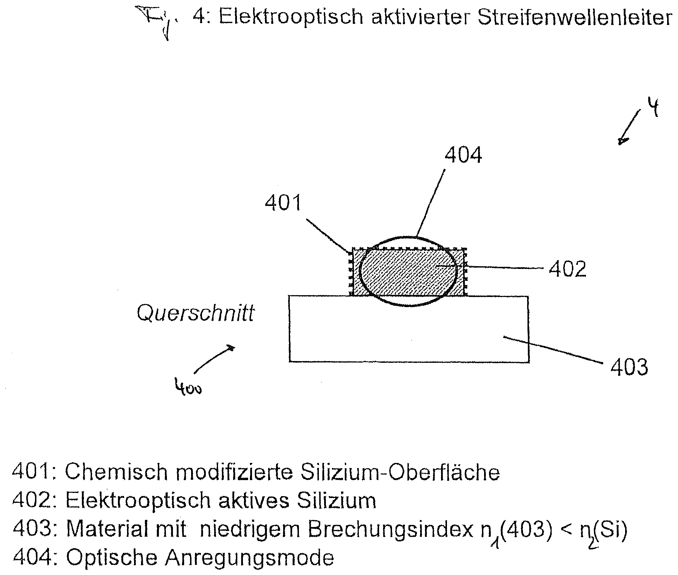

Das Bauelement 4 der Fig. 4 dient wiederum zur Ausbildung eines Wellenleiters mit einer siliziumbasierten Anordnung 400. Als Alternative zu einem in Fig. 3 dargestellten Rippenwellenleiter kann das EO aktive Siliziummaterial 402 mit seiner chemisch modifizierten Oberfläche 401 eine seitlich geringere Abmessung aufweisen als das darunterliegende Material 403 mit niedrigem ersten Brechungsindex n₁. Auch dies führt zu einer ausreichenden Intensitätsüberhöhung der optischen Anregungsmode 404. Die in Fig. 4 gezeigte Anordnung 400 eignet sich besonders für eine Ausbildung eines Streifenwellenleiters.

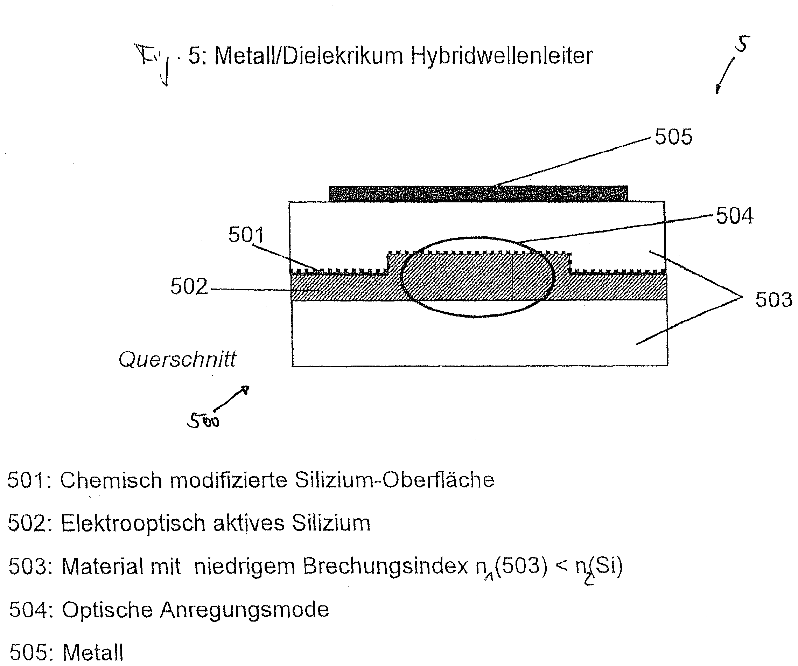

Fig. 5 zeigt eine fünfte Ausführungsform eines EO Bauelements 5 in Form eines Wellenleiters, bei dem die im Querschnitt gezeigte Anordnung 500 praktisch die Anordnung 300 des Bauelements 3 der Fig. 3 enthält. Insofern wird hier lediglich pauschal auf die korrespondierenden Materialien 503 (303), 502 (302) und die Oberfläche 501 (301), wie anhand von Fig. 3 beschrieben, verwiesen. Die optische Anregungsmode 504 ist auch in ihrer freien Höhe einer zusätzlichen Intensitätsüberhöhung dadurch ausgesetzt, dass oberhalb des EO-aktiven Siliziummaterials 502 wiederum ein Material 503 mit niedrigem Brechungsindex n₁ aufgebracht ist. Über dem Material 503 ist eine Metallschicht 505 in Form einer Einzelstreifenleitung aufgebracht, die eine Führung des erzeugten THz-Signals ermöglicht. Neben der Führung der optischen Anregungsmode ist eine phasenangepasste Führung des erzeugten THz-Signals von hoher Bedeutung zur Erreichung einer maximalen Konversionseffizienz. Im Fall einer Differenzfrequenzerzeugung kann die Wellenlänge des erzeugten Signals mehrere Größenordnungen über der Wellenlänge des Pumpsignals liegen. Eine mögliche Ausführungsform eines so genannten Hybridwellenleiters - entsprechend Anordnung 500 - der sowohl die Anregungsmode mit Hilfe eines dielektrischen Wellenleiters als auch die erzeugte Mode mit Hilfe eines metallischen Wellenleiters führt ist in Fig. 5 beispielhaft dargestellt. Das EO-aktive Siliziummaterial 502 ist hier beidseitig von einem Material mit niedrigerem Brechungsindex umgeben, welches durch einen ausreichenden Abstand zur Metallschicht 505 die ungestörte verlustarme Führung der Anregungsmode 504 ermöglicht.

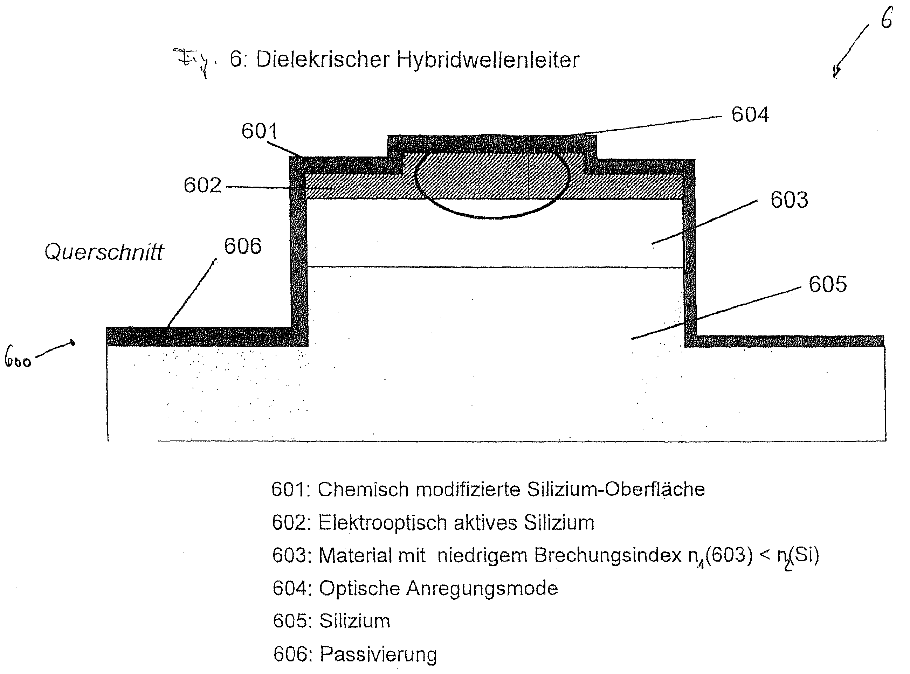

Das in Fig. 6 gezeigte EO Bauelement 6 hat eine siliziumbasierte Anordnung 600, welche im Kern wiederum im Wesentlichen der Anordnung 300 beim Bauelement 3 entspricht, weshalb hier lediglich pauschal auf die korrespondierenden Bezugszeichen 603 (303), 602 (302), 601 (301) und 604 (304) Bezug genommen wird. Zusätzlich ist vorliegend die im Querschnitt gezeigte Anordnung 600 so ausgelegt, dass das Material 603 mit niedrigem Brechungsindex n₁ auf einem Siliziumsubstrat 605 angeordnet ist und zusammen mit dem Siliziumsubstrat 605 mit einer Passivierungsschicht 606 versehen ist. Eine Führung eines erzeugten Signals mit einer größeren Wellenlänge als der Pumpwellenlänge ist durch die Form des Querschnittprofils von Material 605 möglich, der hier einen dielektrischen Rippenwellenleiter bildet. Dadurch ist vorliegend Anordnung 600 als rein dielektrischer Hybridwellenleiter ausgebildet.

Zur Herstellung der elektrooptisch aktivierten Oberfläche 601 (301) mit Silizium-Halogenbindungen können beispielhaft folgende Prozesse verwendet werden: Im Fall einer trockenchemischen Behandlung in einer reaktiven Ionenätzkammer mit Hilfe eines Gasplasmas, z. B. in einem reinen HBr-Plasma bei einem Gasfluss von 40 sccm, einer Prozess dauer von 3-4 sec, einem Kammerdruck von etwa 6mTorr und 100 W RF- und 250 W ICP-Leistung. Im Fall einer nasschemischen Aktivierung wird zunächst die Siliziumoberfläche von Oxiden befreit, z. B. in Flusssäure. Danach gibt man die Siliziumoberfläche in eine schwache Br-Methanol-Lösung für ca. 60 min, wobei Brom-Atome an die Siliziumgrenzflächenatome anbinden.

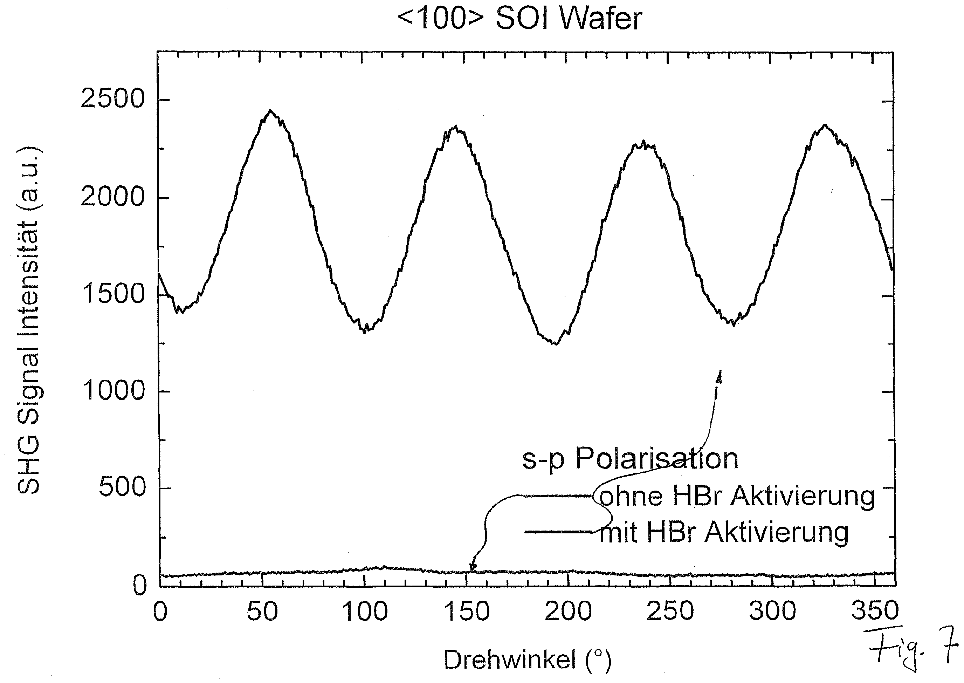

Fig. 7 weist über ein SHG-Signal (Second Harmonic Generation) die Anordnung von SiBr-Bindungen an einer mit HBr aktivierten Si-Oberfläche nach (obere Kurve). Ohne HBr-Aktivierung ist lediglich der Untergrundpegel messbar.

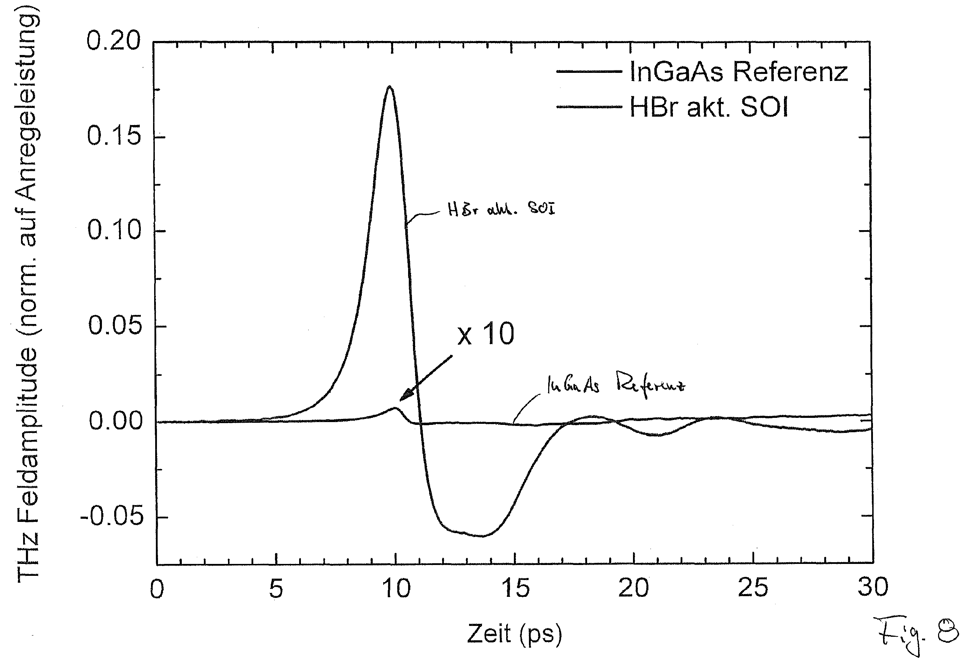

Fig. 8 veranschaulicht die gigantische Amplitude eins THz-Signals von einer mit HBr aktivierten Si-Oberfläche im Vergleich zu einem Standard THz-Emitter InGaAs-Bulkmaterial. Die Pumpleistung beträgt in beiden Fällen etwa 50-100 µW. Die Hbr aktivierte Si-Oberfläche - vorliegend bei einem Wellenleiter - ist in überraschend hohem Maße nichtlinear optisch aktiv.

## Patentansprüche

1. Elektrooptisches Bauelement (1, 2, 3, 4, 5, 6), aufweisend eine Silizium und/oder Germanium basierte Anordnung (100, 200, 300, 400, 500, 600), wobei die Silizium und/oder Germanium basierte Anordnung (100, 200, 300, 400, 500, 600) ein Materialvolumen und ein angrenzendes Material (104, 203, 303, 403, 503, 603) aufweist, wobei das Materialvolumen aus Silizium und/oder Germanium besteht und entsprechend eine Oberfläche (101, 201, 301, 401, 501, 601) aus Silizium und/oder Germanium hat, wobei die Oberfläche (101, 201, 301, 401, 501, 601) mit einer Halogenanreicherung chemisch modifiziert ist, wobei die auf Silizium und/oder Germanium basierte Anordnung (100, 200, 300, 400, 500, 600) eine Schicht des angrenzenden Materials (104, 203, 303, 403, 503, 603) mit einem ersten Brechungsindex n₁ und eine Doppelschicht in dem Materialvolumen aufweist, das Materialvolumen bestehend aus einer elektrooptisch aktiven Schicht (102, 202, 302, 402, 502, 602) und einer elektrooptisch inaktiven Schicht (103), die jeweils einen zweiten Brechungsindex n₂ aufweisen, wobei die elektrooptisch aktive Schicht (102, 202, 302, 402, 502, 602) die chemische Oberflächenmodifizierung (101, 201, 301, 401, 501, 601) in Form von Silizium- und/oder Germanium - Halogen-Bindungen besitzt, welche die elektrooptische Aktivität der elektrooptisch aktiven Schicht (102, 202, 302, 402, 502, 602) verursacht,
und wobei
das Materialvolumen auf dem angrenzenden Material (104, 203, 303, 403, 503, 603) zur Bildung einer Wellenleitanordnung aufgebracht ist und der zweite Brechungsindex n₂ höher ist als der erste Brechungsindex n₁.

2. Bauelement (1, 2, 3, 4, 5, 6) nach Anspruch 1, **dadurch gekennzeichnet, dass** die Halogenanreicherung in Form einer Anreicherung mit einem oder mehreren Anreicherungen ausgewählt ist aus der Gruppe bestehend aus: Bromanreicherung, Fluoranreicherung, Chloranreicherung.

3. Bauelement (1, 2, 3, 4, 5, 6) nach Anspruch 1 oder 2, **dadurch gekennzeichnet, dass** die Halogenanreicherung die Oberfläche durch eine kovalente Bindung des Halogens an ein Silizium- und/oder Germaniumatom der Oberfläche modifiziert und insbesondere das Halogen die Oberfläche in atomarer Form anreichert.

4. Bauelement (1, 2, 3, 4, 5, 6) nach einem der Ansprüche 1 bis 3, **dadurch gekennzeichnet, dass** zwischen der elektrooptisch aktiven Schicht (102, 202, 302, 402, 502, 602) und dem angrenzenden Material (104, 203, 303, 403, 503, 603) die elektrooptisch inaktive Schicht (103) angeordnet ist.

5. Bauelement (1, 2, 3, 4, 5, 6) nach Anspruch 1 **dadurch gekennzeichnet, dass** der erste Brechungsindex n₁ im Bereich von n₁ = 1 bis n₁ = 2,5 wesentlich geringer als der zweite Brechungsindex n₂ im Bereich von n₂ = 3,4 bis n₂ = 3,6 ist.

6. Bauelement (1, 2, 3, 4, 5, 6) nach einem der Ansprüche 1 bis 5 **dadurch gekennzeichnet, dass** bei der Schichtanordnung der Silizium und/oder Germanium basierten Anordnung (100, 200, 300, 400, 500, 600) die elektrooptisch aktive Schicht (102, 202, 302, 402, 502, 602) eine Dicke im Bereich von 50-300 nm und insbesondere im Bereich von 100 - 200 nm hat.

7. Bauelement (1, 2, 3, 4, 5, 6) nach einem der Ansprüche 1 bis 6 **dadurch gekennzeichnet, dass** die Schicht des angrenzenden Materials (104, 203, 303, 403, 503, 603) mit dem niedrigeren ersten Brechungsindex n₁ eine Dicke aufweist, die wesentlich größer als die Dicke der elektrooptisch aktiven Schicht (102, 202, 302, 402, 502, 602) ist.

8. Bauelement (1, 2, 3, 4, 5, 6) nach einem der Ansprüche 1 bis 7 **dadurch gekennzeichnet, dass** die Schicht des angrenzenden Materials (104, 203, 303, 403, 503, 603) mit dem niedrigeren ersten Brechungsindex n₁ eine Dicke im Bereich von 0,5-4 µm und insbesondere im Bereich von 1-3 µm hat.

9. Bauelement (1, 2, 3, 4, 5, 6) nach einem der Ansprüche 1 bis 8 **dadurch gekennzeichnet, dass** das angrenzende Material (104, 203, 303, 403, 503, 603) mit dem niedrigeren ersten Brechungsindex n₁ ein oberhalb der Wellenlänge von 1,1 µm optisch transparentes Material ist.

10. Bauelement (1, 2, 3, 4, 5, 6) nach Anspruch 9 **dadurch gekennzeichnet, dass** das optisch transparente Material ausgewählt ist aus der Gruppe bestehend aus: SiO₂, einem transparenten Polymer, einem Cyclo-Olefin-CoPolymer (COC), einem Benzo-Cyclo-Buthen (BCB), einem SU8 und einem PMMA.

11. Bauelement (1, 2, 3, 4, 5, 6) nach einem der Ansprüche 1 bis 10, **dadurch gekennzeichnet, dass** die elektrooptisch aktive Schicht (102, 202, 302, 402, 502, 602) eine planare Schicht bildet oder eine Rippenstruktur hat und bei einer Rippenstruktur insbesondere ein Wellenleiter in Form eines Rippenwellenleiters gebildet ist.

12. Bauelement (1, 2, 3, 4, 5, 6) nach einem der Ansprüche 1 bis 11, **dadurch gekennzeichnet, dass** die Silizium und/oder Germanium basierte Anordnung (100, 200, 300, 400, 500, 600) Teil einer MESA-Struktur ist, insbesondere ein Wellenleiter in Form eines Streifenwellenleiters gebildet ist und vorzugsweise die elektrooptisch aktive Schicht (102) eine geringere seitliche Abmessung als das angrenzende Material (104, 203, 303, 403, 503, 603) hat.

13. Bauelement (1, 2, 3, 4, 5, 6) nach einem der Ansprüche 1 bis 12, **dadurch gekennzeichnet, dass** auf der Silizium und/oder Germanium basierten Anordnung (100, 200, 300, 400, 500, 600) eine Metall- und/oder Dielektrikum-Abdeckung gebildet ist und insbesondere ein Wellenleiter in Form eines Hybridwellenleiters mit einer Metall- und/oder Dielektrikum-Abdeckung gebildet ist und/oder das Bauelement (1, 2, 3, 4, 5, 6) **gekennzeichnet ist durch** eine Passivierungsschicht (606).

14. Bauelement (1, 2, 3, 4, 5, 6) nach einem der Ansprüche 1 bis 13, **dadurch gekennzeichnet, dass** die auf Silizium und/oder Germanium basierte Anordnung (100, 200, 300, 400, 500) auf einem Silizium- und/oder Germaniumsubstrat gebildet ist.

15. Bauelement (1, 2, 3, 4, 5, 6) nach einem der Ansprüche 1 bis 14, **dadurch gekennzeichnet, dass** die elektrooptisch aktive Schicht (102, 202, 302, 402, 502, 602) gegenüber dem angrenzenden Material (104, 203, 303, 403, 503, 603) mit dem niedrigeren ersten Brechungsindex n₁, mechanisch verspannt ist und/oder elektrisch vorgespannt ist.

16. Wellenleiteranordnung oder Detektor und/oder Modulator oder Strahlungsquelle oder Mess- und/oder Detektionssystem mit einem Bauelement (1, 2, 3, 4, 5, 6) nach einem der Ansprüche 1 bis 15, insbesondere wobei eine Wellenleiteranordnung zur optischen Signalerzeugung im Millimeterwellenlängenbereich, Terahertz-Frequenzbereich und/oder Infrarotbereich ausgelegt ist und/oder wobei die eine längliche Erstreckung der Wellenleiteranordnung im Bereich von 1-10 mm liegt.

17. Herstellungsverfahren für ein elektrooptisches Bauelement (1, 2, 3, 4, 5, 6) nach einem der vorhergehenden Ansprüche, aufweisend die Schritte:
- zur Verfügung stellen eines Materials (104, 203, 303, 403, 503, 603) eines ersten Brechungsindexes n₁;
- Aufbringen eines elektrooptisch zu aktivierenden Siliziums und/oder Germaniums eines zweiten Brechungsindexes n₂ als ein Materialvolumen und mit einer Oberfläche (101, 201, 301, 401, 501, 601);
- chemisches Modifizieren der Oberfläche (101, 201, 301, 401, 501, 601) durch eine Halogenanreicherung derart, dass das Silizium und/oder Germanium elektrooptisch aktiviert wird, wobei
die Silizium und/oder Germanium basierte Anordnung (100, 200, 300, 400, 500, 600) als Schichtanordnung ausgeführt wird, wobei eine Schicht des Materials (104, 203, 303, 403, 503, 603) mit dem ersten Brechungsindex n₁ und eine Doppelschicht in dem Materialvolumen bestehend aus einer elektrooptisch aktiven Schicht (102, 202, 302, 402, 502, 602) und einer elektrooptisch inaktiven Schicht (103), die jeweils einen zweiten Brechungsindex n₂ aufweisen, ausgeführt wird, wobei die elektrooptisch aktive Schicht (102, 202, 302, 402, 502, 602) die chemische Oberflächenmodifizierung (101, 201, 301, 401, 501, 601) in Form von Silizium-und/oder Germanium - Halogen-Bindungen besitzt, welche die elektrooptische Aktivität der elektrooptisch aktiven Schicht (102, 202, 302, 402, 502, 602) verursacht, und wobei
das Materialvolumen auf dem Material (104, 203, 303, 403, 503, 603) mit dem ersten Brechungsindex n₁ zur Bildung einer Wellenleitanordnung aufgebracht wird, wobei der zweite Brechungsindex n₂ höher ist als der erste Brechungsindex n₁.

18. Herstellungsverfahren nach Anspruch 17, **dadurch gekennzeichnet, dass** zwischen der elektrooptisch aktiven Schicht (102, 202, 302, 402, 502, 602) und einem Silizium- und/oder Germaniumsubstrat (605) das Material (104, 203, 303, 403, 503, 603) des niedrigeren ersten Brechungsindexes n₁ angebracht wird, wobei der erste Brechungsindex n₁ wesentlich geringer als der zweite Brechungsindex n₂ der elektrooptisch aktiven Schicht (102, 202, 302, 402, 502, 602) ist.

19. Herstellungsverfahren nach Anspruch 17 oder 18, **dadurch gekennzeichnet, dass** die Oberfläche (101, 201, 301, 401, 501, 601) nasschemisch behandelt wird und/oder in einem Plasmaverfahren, insbesondere in einem Trockenplasmaverfahren oder RIE-Verfahren, plasmaaktiviert wird.

## Claims

1. Electro-optical component (1, 2, 3, 4, 5, 6), comprising a silicon- and/or germanium-based arrangement (100, 200, 300, 400, 500, 600), wherein the silicon- and/or germanium-based arrangement (100, 200, 300, 400, 500, 600) comprises a material volume and an adjoining material (104, 203, 303, 403, 503, 603), wherein the material volume consists of silicon and/or germanium and accordingly has a surface (101, 201, 301, 401, 501, 601) composed of silicon and/or germanium, wherein the surface (101, 201, 301, 401, 501, 601) is chemically modified by a halogen enrichment, wherein the silicon- and/or germanium-based arrangement (100, 200, 300, 400, 500, 600) comprises a layer of the adjoining material (104, 203, 303, 403, 503, 603) having a first refractive index n₁ and a double layer in the material volume, the material volume consisting of an electro-optically active layer (102, 202, 302, 402, 502, 602) and an electro-optically inactive layer (103), each having a second refractive index n₂, wherein the electro-optically active layer (102, 202, 302, 402, 502, 602) has the chemical surface modification (101, 201, 301, 401, 501, 601) in the form of silicon- and/or germanium-halogen bonds, which causes the electro-optical activity of the electro-optically active layer (102, 202, 302, 402, 502, 602), and wherein the material volume is applied on the adjoining material (104, 203, 303, 403, 503, 603) in order to form a waveguide arrangement, and the second refractive index n₂ is higher than the first refractive index n₁.

2. Component (1, 2, 3, 4, 5, 6) according to Claim 1, **characterized in that** the halogen enrichment in the form of an enrichment with one or more enrichments is selected from the group consisting of: bromine enrichment, fluorine enrichment, chlorine enrichment.

3. Component (1, 2, 3, 4, 5, 6) according to Claim 1 or 2, **characterized in that** the halogen enrichment modifies the surface by means of a covalent bonding of the halogen to a silicon and/or germanium atom of the surface and, in particular, the halogen enriches the surface in atomic form.

4. Component (1, 2, 3, 4, 5, 6) according to any of Claims 1 to 3, **characterized in that** the electro-optically inactive layer (103) is arranged between the electro-optically active layer (102, 202, 302, 402, 502, 602) and the adjoining material (104, 203, 303, 403, 503, 603).

5. Component (1, 2, 3, 4, 5, 6) according to Claim 1, **characterized in that** the first refractive index n₁ in the range of n₁ = 1 to n₁ = 2.5 is significantly lower than the second refractive index n₂ in the range of n₂ = 3.4 to n₂ = 3.6.

6. Component (1, 2, 3, 4, 5, 6) according to any of Claims 1 to 5, **characterized in that** in the case of the layer arrangement of the silicon- and/or germanium-based arrangement (100, 200, 300, 400, 500, 600), the electro-optically active layer (102, 202, 302, 402, 502, 602) has a thickness in the range of 50-300 nm and in particular in the range of 100 - 200 nm.

7. Component (1, 2, 3, 4, 5, 6) according to any of Claims 1 to 6, **characterized in that** the layer of the adjoining material (104, 203, 303, 403, 503, 603) having the lower first refractive index n₁ has a thickness that is significantly greater than the thickness of the electro-optically active layer (102, 202, 302, 402, 502, 602).

8. Component (1, 2, 3, 4, 5, 6) according to any of Claims 1 to 7, **characterized in that** the layer of the adjoining material (104, 203, 303, 403, 503, 603) having the lower first refractive index n₁ has a thickness in the range of 0.5 - 4 µm and in particular in the range of 1 - 3 µm.

9. Component (1, 2, 3, 4, 5, 6) according to any of Claims 1 to 8, **characterized in that** the adjoining material (104, 203, 303, 403, 503, 603) having the lower first refractive index n₁ is a material that is optically transparent above the wavelength of 1.1 µm.

10. Component (1, 2, 3, 4, 5, 6) according to Claim 9, **characterized in that** the optically transparent material is selected from the group consisting of: SiO₂, a transparent polymer, a cycloolefin copolymer (COC), a benzocyclobutene (BCB), an SU8 and a PMMA.

11. Component (1,2,3,4,5,6) according to any of Claims 1 to 10, **characterized in that** the electro-optically active layer (102, 202, 302, 402, 502, 602) forms a planar layer or has a ridge structure and, in the case of a ridge structure, in particular a waveguide in the form of a ridge waveguide is formed.

12. Component (1, 2, 3, 4, 5, 6) according to any of Claims 1 to 11, **characterized in that** the silicon- and/or germanium-based arrangement (100, 200, 300, 400, 500, 600) is part of a MESA structure, in particular a waveguide in the form of a strip waveguide is formed, and preferably the electro-optically active layer (102) has a smaller lateral dimension than the adjoining material (104, 203, 303, 403, 503, 603).

13. Component (1, 2, 3, 4, 5, 6) according to any of Claims 1 to 12, **characterized in that** a metal and/or dielectric cover is formed on the silicon- and/or germanium-based arrangement (100, 200, 300, 400, 500, 600), and in particular a waveguide in the form of a hybrid waveguide with a metal and/or dielectric cover is formed and/or the component (1, 2, 3, 4, 5, 6) is **characterized by** a passivation layer (606).

14. Component (1, 2, 3, 4, 5, 6) according to any of Claims 1 to 13, **characterized in that** the silicon- and/or germanium-based arrangement (100, 200, 300, 400, 500) is formed on a silicon and/or germanium substrate.

15. Component (1, 2, 3, 4, 5, 6) according to any of Claims 1 to 14, **characterized in that** the electro-optically active layer (102, 202, 302, 402, 502, 602) is mechanically stressed and/or electrically biased relative to the adjoining material (104, 203, 303, 403, 503, 603) having the lower first refractive index n₁.

16. Waveguide arrangement or detector and/or modular or radiation source or measurement and/or detection system comprising a component (1, 2, 3, 4, 5, 6) according to any of Claims 1 to 15, in particular wherein a waveguide arrangement is designed for optical signal generation in the millimetre wavelength range, terahertz frequency range and/or infrared range and/or wherein the elongate extent of the waveguide arrangement is in the range of 1-10 mm.

17. Production method for an electro-optical component (1, 2, 3, 4, 5, 6) according to any of the preceding claims, comprising the following steps:
- making available a material (104, 203, 303, 403, 503, 603) having a first refractive index n₁;
- applying a silicon and/or germanium to be activated electro-optically and having a second refractive index n₂ as a material volume and having a surface (101, 201, 301, 401, 501, 601);
- chemically modifying the surface (101, 201, 301, 401, 501, 601) by means of a halogen enrichment in such a way that the silicon and/or germanium are/is activated electro-optically, wherein the silicon- and/or germanium-based arrangement (100, 200, 300, 400, 500, 600) is embodied as a layer arrangement, wherein a layer of the material (104, 203, 303, 403, 503, 603) having the first refractive index n₁ and a double layer are embodied in the material volume consisting of an electro-optically active layer (102, 202, 302, 402, 502, 602) and an electro-optically inactive layer (103), each having a second refractive index n₂, wherein the electro-optically active layer (102, 202, 302, 402, 502, 602) has the chemical surface modification (101, 201, 301, 401, 501, 601) in the form of silicon- and/or germanium-halogen bonds, which causes the electro-optical activity of the electro-optically active layer (102, 202, 302, 402, 502, 602), and wherein the material volume is applied on the material (104, 203, 303, 403, 503, 603) having the first refractive index n₁ in order to form a waveguide arrangement, wherein the second refractive index n₂ is higher than the first refractive index n₁.

18. Production method according to Claim 17, **characterized in that** the material (104, 203, 303, 403, 503, 603) having the lower first refractive index n₁ is applied between the electro-optically active layer (102, 202, 302, 402, 502, 602) and a silicon and/or germanium substrate (605), wherein the first refractive index n₁ is significantly lower than the second refractive index n₂ of the electro-optically active layer (102, 202, 302, 402, 502, 602).

19. Production method according to Claim 17 or 18, **characterized in that** the surface (101, 201, 301, 401, 501, 601) is subjected to wet-chemical treatment and/or is plasma-activated in a plasma method, in particular in a dry plasma method or an RIE method.

## Revendications

1. Composant (1, 2, 3, 4, 5, 6) électro-optique ayant un agencement (100, 200, 300, 400, 500, 600) à base de silicium et/ou de germanium, dans lequel
l'agencement (100, 200, 300, 400, 500, 600) à base de silicium et/ou de germanium a un volume de matériau et un matériau (104, 203, 303, 403, 503, 603) voisin,
le volume de matériau est en silicium et/ou en germanium et, en conséquence, a une surface (101, 201, 301, 401, 501, 601) en silicium et/ou en germanium,
dans lequel
la surface (101, 201, 301, 401, 501, 601) est modifiée chimiquement par un enrichissement en halogène, dans lequel
l'agencement (100, 200, 300, 400, 500, 600) a base de silicium et/ou de germanium a une couche du matériau (104, 203, 303, 403, 503, 603) voisin ayant un premier indice n₁ de réfraction et a une couche double dans le volume de matériau, le volume de matériau étant constitué d'une couche (102, 202, 302, 402, 502, 602) active électro-optiquement et d'une couche (103) inactive électro-optiquement qui ont chacune un deuxième indice n₂ de réfraction, la couche (102, 2023, 302, 402, 502, 602) active électro-optiquement, qui possède la modification (101, 201, 301, 401, 501, 601) chimique de surface, possédant des composés sous forme de silicium-halogène et/ou germanium-halogène qui provoquent l'activité électro-optique de la couche (102, 202, 302, 402, 502, 602) active électro-optiquement,
et dans lequel
le volume de matériau est déposé sur le matériau (104, 203, 303, 403, 503, 603) voisin pour former un agencement de guide d'onde et
le deuxième indice n₂ de réfraction est plus grand que le premier indice n₁ de réfraction.

2. Composant (1, 2, 3, 4, 5, 6) suivant la revendication 1, **caractérisé en ce que** l'enrichissement en halogène est choisi sous la forme d'un enrichissement en un ou en plusieurs enrichissements choisis dans le groupe constitué d'un enrichissement en brome, d'un enrichissement en fluor, d'un enrichissement en chlore.

3. Composant (1, 2, 3, 4, 5, 6) suivant la revendication 1 ou 2, **caractérisé en ce que** l'enrichissement en halogène modifie la surface par une liaison covalente de l'halogène sur un atome de silicium et/ou de germanium de la surface et notamment l'halogène enrichit la surface sous forme atomique.

4. Composant (1, 2, 3, 4, 5, 6) suivant l'une des revendications 1 à 3, **caractérisé en ce que** la couche (103) inactive électro-optiquement est disposée entre la couche (102, 202, 302, 402, 502, 602) active électro-optiquement et le matériau (104, 203, 303, 403, 503, 603) voisin.

5. Composant (1, 2, 3, 4, 5, 6) suivant la revendication 1, **caractérisé en ce que** le premier indice n₁ de réfraction est dans la plage de n₁ = 1 à n₁ = 2,5 en étant sensiblement plus petit que le deuxième indice n₂ de réfraction dans la plage de n₂ = 3, 4 à n₂ = 3,6.

6. Composant (1, 2, 3, 4, 5, 6) suivant l'une des revendications 1 à 5, **caractérisé en ce que**, dans le stratifié de l'agencement de couche (100, 200, 300, 400, 500, 600) à base de silicium et/ou de germanium, la couche (102, 202, 302, 402, 502, 602) active électro-optiquement a une épaisseur dans la plage de 50 à 300 nm et notamment dans la plage de 100 à 200 nm.

7. Composant (1, 2, 3, 4, 5, 6) suivant l'une des revendications 1 à 6, **caractérisé en ce que** la couche du matériau (104, 203, 303, 403, 503, 603) voisin, ayant le premier indice n₁ de réfraction plus petit, a une épaisseur qui est sensiblement plus grande que l'épaisseur de la couche (102, 202, 302, 402, 502, 602) active électro-optiquement.

8. Composant (1, 2, 3, 4, 5, 6) suivant l'une des revendications 1 à 7, **caractérisé en ce que** la couche du matériau (104, 203, 303, 403, 503, 603) voisin, ayant le premier indice n₁ de réfraction, a une épaisseur dans la plage de 0,5 à 4 µm et notamment dans la plage de 1 à 3 µm.

9. Composant (1, 2, 3, 4, 5, 6) suivant l'une des revendications 1 à 8, **caractérisé en ce que** le matériau (104, 203, 303, 403, 503, 603) voisin, ayant le premier indice n₁ de réfraction plus petit, est un matériau transparent optiquement au-dessus des longueurs d'onde de 1,1 µm.

10. Composant (1, 2, 3, 4, 5, 6) suivant la revendication 9, **caractérisé en ce que** le matériau transparent optiquement est choisi dans le groupe constitué de : SiO₂, un polymère transparent, un polymère cyclo-oléfinique (COC), un benzo-cyclo-butène, un SUB et un PMMA.

11. Composant (1, 2, 3, 4, 5, 6) suivant l'une des revendications 1 à 10, **caractérisé en ce que** la couche (102, 202, 302, 402, 502, 602) active électro-optiquement forme une couche plane ou a une structure nervurée et, s'il y a une structure nervurée, il est formé notamment un guide d'onde sous la forme d'un guide d'onde nervuré.

12. Composant (1, 2, 3, 4, 5, 6) suivant l'une des revendications 1 à 11, **caractérisé en ce que** l'agencement (100, 200, 300, 400, 500, 600) à base de silicium et/ou de germanium fait partie d'une structure MESA, un guide d'onde sous la forme d'un guide d'onde à ruban étant notamment formé et, de préférence, la couche (102) active électro-optiquement a une dimension latérale plus petite que le matériau (104, 203, 303, 403, 503, 603) voisin.

13. Composant (1, 2, 3, 4, 5, 6) suivant l'une des revendications 1 à 12, **caractérisé en ce que**, sur l'agencement (100, 200, 300, 400, 500, 600) à base de silicium et/ou de germanium, est formé un recouvrement métallique et/ou diélectrique et il est formé notamment un guide d'onde sous la forme d'un guide d'onde hybride ayant un recouvrement métallique et/ou diélectrique et/ou le composant (1, 2, 3, 4, 5, 6) est **caractérisé par** une couche (606) de passivation.

14. Composant (1, 2, 3, 4, 5, 6) suivant l'une des revendications 1 à 13, **caractérisé en ce que** l'agencement (100, 200, 300, 400, 500) à base de silicium et/ou de germanium est formé d'un substrat en silicium et/ou en germanium.

15. Composant (1, 2, 3, 4, 5, 6) suivant l'une des revendications 1 à 14, **caractérisé en ce que** la couche (102, 202, 302, 402, 502, 602) active électro-optiquement est, par rapport au matériau (104, 203, 303, 403, 503, 603) voisin ayant l'indice n₁ de réfraction plus petit, bloquée mécaniquement et/ou polarisée électriquement.

16. Agencement de guide d'onde ou détecteur et/ou modulateur ou source de rayonnement ou système de mesure et/ou de détection comprenant un composant (1, 2, 3, 4, 5, 6) suivant l'une des revendications 1 à 15, dans lequel notamment un agencement de guide d'onde est conçu pour la production optique de signaux dans le domaine des longueurs d'onde du millimètre, le domaine de séquence du térahertz et/ou le domaine infrarouge et/ou dans lequel l'étendue longitudinale de l'agencement de guide d'onde est dans la plage de 1 à 10 mm.

17. Procédé de production d'un composant (1, 2, 3, 4, 5, 6) électro-optique suivant l'une des revendications précédentes, comprenant les stades :
- on se procure un matériau (104, 203, 303, 403, 503, 603) ayant un premier indice n₁ de réfraction ;
- on dépose un silicium et/ou un germanium à activer électro-optiquement d'un deuxième indice n₂ de réfraction comme matériau de volume et ayant une surface (101, 201, 301, 401, 501, 601) ;
- on modifie chimiquement la surface (101, 201, 301, 401, 501, 601) par un enrichissement en halogène de manière à activer électro-optiquement le silicium et/ou le germanium ;
- on réalise l'agencement (100, 200, 300, 400, 500, 600) de silicium et/ou de germanium sous la forme d'un stratifié, une couche du matériau (104, 203, 303, 403, 503, 603) ayant le premier indice n₁ de réfraction et une couche double dans le volume de matériau en une couche (102, 302, 402, 502, 602) active électro-optiquement et en une couche (103) inactive électro-optiquement, qui ont chacune un deuxième indice n₂ de réfraction, étant réalisées, la couche (102, 202, 302, 402, 502, 602) active électro-optiquement possédant la modification (101, 201, 301, 401, 501, 601) de surface sous la forme de composés de silicium et/ou germanium-halogène, qui provoque l'activité électro-optique de la couche (102, 202, 302, 402, 502, 602) active électro-optiquement,
et dans lequel
on dépose le volume de matériau sur le matériau (104, 203, 303, 403, 503, 603) ayant le premier indice n₁ de réfraction pour former un agencement de guide d'onde, dans lequel
le deuxième indice n₂ de réfraction est plus grand que le premier indice n₁ de réfraction.

18. Procédé de production suivant la revendication 17, **caractérisé en ce que** l'on met le matériau (104, 203, 303, 403, 503, 603), ayant le premier indice n₁ de réfraction plus petit, entre la couche (102, 202, 302, 402, 502, 602) active électro-optiquement et un substrat (605) en silicium et/ou en germanium, dans lequel le premier indice n₁ de réfraction est sensiblement plus petit que le deuxième indice n₂ de réfraction de la couche (102, 202, 302, 402, 502, 602) active électro-optiquement.

19. Procédé de production suivant la revendication 17 ou 18, **caractérisé en ce que** l'on traite la surface (101, 201, 301, 401, 501, 601) chimiquement en voie humide et/ou on l'active par plasma dans un procédé au plasma, notamment dans un procédé au plasma sec ou dans un procédé RIE.
